# DEMANDE DE BREVET EUROPEEN

(11) **EP 4 071 829 A1**
(43) Date de publication de la demande: **12.10.2022**
(21) Numéro de dépôt: 22165539.2
(22) Date de dépôt: 30.03.2022
(51) Int. Cl.: H01L 29/778, H01L 29/417, H01L 29/20, H01L 25/07, H01L 27/06

(54) **DISPOSITIF ÉLECTRONIQUE COMPRENANT DEUX TRANSISTORS À HAUTE MOBILITÉ ÉLECTRONIQUE**

(30) Priorité: 07.04.2021 FR 2103561
(71) Demandeur: Exagan, 38040 Grenoble Cedex 9 (FR); STMicroelectronics International N.V., 1228 Plan-les-Ouates, Geneva (CH)
(72) Inventeur: NONGAILLARD, Matthieu, 38000 GRENOBLE (FR); OHEIX, Thomas, 38100 GRENOBLE (FR)
(74) Mandataire: Cabinet Beaumont

(57) **Abrégé**

L'invention concerne un dispositif électronique pourvu de deux transistors (101, 102) à haute mobilité électronique empilés l'un sur l'autre et ayant en commun leurs électrodes de source, de drain, et de grille.

Notamment, chacune de ces électrodes s'étend perpendiculairement aux deux transistors. Notamment, les électrodes de source (203) et de drain (204) contactent électriquement les canaux de conduction (201c, 202c) de chacun des transistors de sorte que lesdits canaux sont électriquement connectés en parallèle.

## Description

### DOMAINE DE L'INVENTION

L'invention se rapporte au domaine de l'électronique, et notamment de l'électronique de puissance. Plus particulièrement, la présente invention concerne un dispositif électronique pourvu de deux transistors à haute mobilité électronique.

Le dispositif selon la présente invention est notamment agencé pour permettre une meilleure intégration des deux transistors à haute mobilité électronique.

L'agencement prévu dans la présente invention permet à cet égard l'obtention d'un dispositif compact et permettant d'augmenter la densité de courant susceptible de traverser ledit le dispositif au regard d'un unique transistor à haute mobilité électronique.

### ARRIERE PLAN TECHNOLOGIQUE DE L'INVENTION

Les transistors à haute mobilité électronique (« HEMT » ou « High Electron Mobility Transistor » selon la terminologie Anglo-Saxonne), bien connus de l'homme du métier, sont aujourd'hui largement mis en œuvre dans le domaine des hyperfréquences et celui des commutateurs pour les convertisseurs en électronique de puissance.

A cet égard, ces transistors HEMT sont généralement élaborés à partir de couches de matériaux semi-conducteurs III-V et plus particulièrement des matériaux semi-conducteurs III-N.

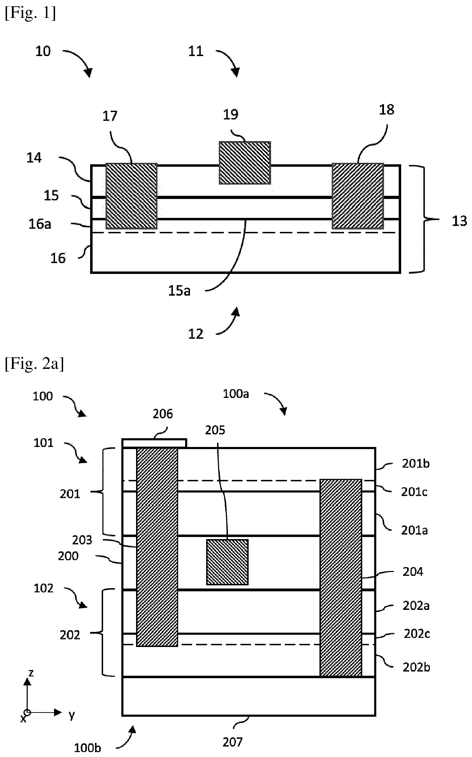

Notamment, la figure 1 représente un transistor HEMT 10 connu de l'état de la technique. Ce transistor HEMT 10 est pourvu d'un empilement 13 qui comprend, d'une face avant 11 vers une face arrière 12, une couche d'isolant 14, une couche barrière 15 et une couche canal 16 apte à former une couche de conduction 16a sous forme d'une couche de gaz électronique à deux dimensions. En particulier, la couche de conduction 16a s'étend dans la couche canal 16 à partir d'une interface 15a, formée entre la couche barrière 15 et ladite couche canal 16.

Les matériaux semi-conducteurs III-V choisis pour former la couche barrière 15 et/ou la couche canal 16 peuvent comprendre du nitrure de gallium (GaN), du nitrure d'aluminium (AlN), des alliages ternaires AlxGa1-xNx, de l'arséniure de gallium (GaAs), des alliages ternaires d'AlGaAs ou d'InGaAs. Par exemple, la couche barrière 15 et la couche canal 16 peuvent comprendre, respectivement, un composé d'AlGaN et du GaN. La couche d'isolant 14 peut comprendre un matériau diélectrique et notamment du dioxyde de silicium (SiO2) ou nitrure de silicium (Si3N4).

Le transistor HEMT 10 comprend également une électrode de source 17 et une électrode de drain 18 en contact électrique avec la couche de conduction 16a. Plus particulièrement, l'électrode de source 17 et l'électrode de drain 18 débouchent par la face avant 11, et traversent la couche d'isolant 14 et la couche barrière 15 afin d'atteindre l'interface 15a et contacter électriquement la couche de conduction 16a. L'électrode de source 17 et de l'électrode de drain 18 peuvent traverser partiellement ou intégralement la couche de conduction 16a. L'électrode de source 17 et l'électrode de drain 18 peuvent comprendre une espèce métallique, par exemple de l'aluminium, remplissant des tranchées formées dans l'empilement 13.

Le transistor HEMT 10 comprend également une électrode de grille 19 destinée à se voir imposer une tension Vg permettant de contrôler l'état de la couche de conduction 16a. Notamment, dès lors que la différence de potentiel électrique entre l'électrode de grille 19 et l'électrode de source 17, notée Vg-Vs, est supérieure à une tension de seuil Vth caractéristique du transistor HEMT 10, ledit transistor est dans l'état passant. A contrario, dès lors que Vg-Vs est inférieure à Vth, le transistor HEMT 10 est dans l'état non-passant, et se comporte donc comme un interrupteur ouvert.

Aussi, dépendamment de la valeur de la tension de seuil Vth, et plus particulièrement de son signe, un transistor HEMT peut être en mode déplétion (« normally on » selon la terminologie Anglo-Saxonne) si sa tension de seuil Vth est négative, ou en mode enrichissement (« normally off » selon la terminologie Anglo-Saxonne) si sa tension de seuil Vth est positive.

Un tel transistor à haute mobilité électronique présente toutefois une résistivité Ron (Ron étant la résistance drain/source à l'état passant) à l'état passant qui limite l'intensité du courant susceptible de circuler dans la couche de conduction.

A cet égard, les principaux paramètres influençant la résistivité Ron sont :
- la résistance surfacique de la couche canal ;
- la résistance des contacts entre la couche de conduction et les électrodes de source et de drain ;
- les résistivités électriques des métaux de routage des puces ;
- les résistances électriques induites dans l'assemblage final dans lequel est intégré le transistor à haute mobilité électronique.

Afin de pallier ce problème, il est possible de réduire de manière significative la résistivité Ron d'un transistor à haute mobilité électronique en augmentant la surface de ce dernier. Il est néanmoins des situations pour lesquelles l'espace disponible pour l'intégration d'un transistor à haute mobilité électronique est contraint de sorte qu'une telle solution ne puisse être envisagée.

De manière alternative, il peut être considéré d'optimiser les paramètres influençant la résistivité Ron. Une telle solution reste cependant complexe à mettre en œuvre, car elle nécessite, d'une part, un redimensionnement complet du transistor à haute mobilité électronique, et d'autre part une revue du procédé permettant de fabriquer ledit transistor.

Un but de la présente invention est donc de proposer un dispositif dont l'agencement permet une densité d'intégration de transistors à haute mobilité électronique plus importante sans toutefois augmenter de manière significative l'espace occupé par ledit dispositif.

### BREVE DESCRIPTION DE L'INVENTION

Le but de l'invention est atteint par un dispositif électronique comprenant deux transistors à haute mobilité électronique dits, respectivement, premier et deuxième transistors, le premier et le deuxième transistors étant chacun pourvus d'un empilement dits, respectivement, premier et deuxième empilements, le premier et le deuxième empilements s'étendent, d'une interface vers, respectivement, une face avant et une face arrière du dispositif électronique, et comprennent chacun, à partir de l'interface, une couche barrière et une couche canal apte à former une couche de conduction sous forme d'un gaz d'électrons à deux dimensions, les deux transistors ayant en commun une électrode de source et une électrode de drain agencées de sorte que des chemins de conduction électrique susceptibles d'être formés par les deux couches de conduction soient connectés en parallèle, les deux transistors ont également en commun une électrode de grille permettant d'imposer un état passant ou un état non passant à l'une et l'autre des deux couches de conduction.

Ainsi, selon la présente invention il est possible d'augmenter la densité de transistors à haute mobilité électronique sans pour autant augmenter la surface que le dispositif électronique occupe.

Par ailleurs, la mise en parallèle des couches conduction des deux transistors permet d'augmenter le courant susceptible de circuler dans le dispositif électronique et ainsi ouvrir la voie à des applications plus haute puissance.

En outre, le dispositif électronique selon la présente invention ne nécessite pas de redimensionnement des transistors à haute mobilité électronique qu'il comprend.

Par surcroit, la connexion en parallèle des chemins de conduction permet de limiter la résistivité Ron du dispositif électronique.

Selon un mode de mise en œuvre, l'interface comprend une couche isolante s'intercalant entre les couches barrière des deux empilements, avantageusement, la couche isolante comprend du dioxyde de silicium.

La mise en œuvre de la couche isolante est particulièrement avantageuse, dans la mesure où elle permet d'isoler efficacement les deux couches barrière.

La considération de cette couche isolante simplifie également l'assemblage des deux transistors à haute mobilité électronique. En effet, cette dernière permet de considérer un assemblage par collage moléculaire des deux transistors.

Selon un mode de mise en œuvre, l'électrode de source et l'électrode de drain traversent la couche isolante, et s'étendent chacune de part et d'autre de ladite couche isolante pour, chacune, contacter électriquement les deux couches de conduction.

Selon un mode de mise en œuvre, ledit dispositif électrique comprend un plot, dit plot source, disposé sur la face avant et permettant de contacter électriquement l'électrode de source.

Selon un mode de mise en œuvre, ledit dispositif électrique comprend un support contact sur lequel reposent les deux transistors à haute mobilité électronique par la couche barrière sur le deuxième transistor.

Selon un mode de mise en œuvre, ledit dispositif électrique comprend un plot, dit plot grille, disposé sur la face avant et permettant de contacter électriquement l'électrode de grille.

Selon un mode de mise en œuvre, le premier empilement repose par sa couche canal sur un support contact, ledit support contact formant un plot de contact conducteur électriquement connecté à l'électrode de drain, le support contact comprenant avantageusement du silicium dopé.

Selon un mode de mise en œuvre, le premier et le deuxième empilements sont essentiellement identiques.

Selon un mode de mise en œuvre, le premier et le deuxième transistors présentent une tension de seuil identique.

Selon un mode de mise en œuvre, le premier et le deuxième transistors présentent chacun, respectivement, une première tension de seuil et une deuxième tension de seuil différentes l'une de l'autre.

Selon un mode de mise en œuvre, le premier et le deuxième transistors sont des transistors à haute mobilité électronique en mode enrichissement.

Selon un mode de mise en œuvre, le premier et le deuxième transistors sont des transistors à haute mobilité électronique en mode déplétion.

Selon un mode de mise en œuvre, l'électrode de source est cascodée avec un transistor à effet de champ à grille métal-oxyde.

Selon un mode de mise en œuvre, les deux couches canal comprennent du GaN et les couches barrière comprennent un alliage ternaire d'AlGaN.

### BREVE DESCRIPTION DES DESSINS

D'autres caractéristiques et avantages de l'invention ressortiront de la description détaillée qui va suivre en référence aux figures annexées sur lesquelles :
la figure 1 est une représentation schématique d'un transistor HEMT connu de l'état de la technique, notamment, le transistor HEMT est représenté selon un plan de coupe perpendiculaire à la face avant ;
la figure 2a est une représentation schématique d'un dispositif électronique, selon un plan de coupe, conforme à la présente invention ;
la figure 2b est une représentation illustrant le positionnement déporté du plot grille permettant de connecter électriquement l'électrode de grille du dispositif électronique de la figure 2a ;
la figure 2c est une représentation illustrant le positionnement déporté du plot grille permettant de connecter électriquement l'électrode de grille du dispositif électronique de la figure 2a selon une vue par la face avant dudit dispositif ;
la figure 3 est une représentation schématique d'un dispositif électronique, selon un plan de coupe, conforme à la présente invention, et dans lequel le premier transistor et le deuxième transistor sont des transistors normalement passants, et sont cascodés ;
la figure 4 est une représentation schématique d'une étape de formation d'un premier transistor selon les termes de la présente invention ;
la figure 5 est une représentation schématique d'une étape de formation d'un deuxième transistor selon les termes de la présente invention ;
la figure 6 est une représentation schématique d'une étape d'assemblage selon les termes de la présente invention ;
la figure 7 est une représentation schématique d'une étape de formation de plots destinés à contacter électriquement les électrodes de source et de grille.

### DESCRIPTION DETAILLEE DE L'INVENTION

Bien sûr, l'invention n'est pas limitée aux modes de réalisation décrits et on peut y apporter des variantes de réalisation sans sortir du cadre de l'invention tel que défini par les revendications.

Par ailleurs, il est entendu que les différentes figures présentées en relation avec la présente description ne sont données qu'à titre d'illustration et ne limitent en aucune manière l'invention. Il est notamment clair que les échelles ou dimensions relatives peuvent ne pas être respectées.

Dans toute la description, il est admis qu'une couche ou une interface est généralement plane et s'étend selon un plan parallèle au plan (0, x, y) du repère orthonormé (0, x, y, z). Par ailleurs, dès qu'il est fait référence à une représentation selon un plan de coupe, ce dernier est perpendiculaire à l'ensemble des plans formés par les couches, et plus particulièrement perpendiculaire au plan (0, x, y). Il est également entendu que, dès lors qu'il est fait référence à un empilement de couches, ces dernières sont empilées selon la direction z du repère orthonormé (0, x, y, z) .

L'invention concerne un dispositif électronique pourvu de deux transistors à haute mobilité électronique empilés l'un sur l'autre et ayant en commun leurs électrodes de source, de drain, et de grille.

Notamment, chacune de ces électrodes s'étend perpendiculairement aux deux transistors. Notamment, les électrodes de source et de drain contactent électriquement les canaux de conduction de chacun des transistors de sorte que lesdits canaux sont électriquement connectés en parallèle.

Cette configuration est avantageuse à plusieurs égards. En effet, la mise en parallèle des canaux de conduction des deux transistors permet d'augmenter l'intensité du courant susceptible de circuler dans le dispositif électronique sans avoir à augmenter sa surface. Par ailleurs, cette mise en parallèle permet également de réduire la résistivité à l'état passant Ron du dispositif électronique.

A la figure 2a, on peut voir un exemple de dispositif électronique 100 selon un mode de réalisation avantageux de la présente invention.

Ainsi, le dispositif électronique 100 selon la présente invention comprend deux transistors à haute mobilité électronique (ci-après « transistor HEMT »). Notamment, le dispositif électronique 100 comprend, d'une face avant 100a vers une face arrière 100b, un premier transistor HEMT 101 et un deuxième transistor HEMT 102 séparés par une couche isolante 200. La couche isolante 200 comprend avantageusement du dioxyde de silicium.

Le premier transistor 101 et le deuxième transistor 102 comprennent chacun un empilement dit, respectivement, premier empilement 201 et deuxième empilement 202. Chacun de ces empilements peut notamment comprendre des matériaux semi-conducteurs du groupe III-V, et plus particulièrement des matériaux semi-conducteurs du groupe III-N. Les matériaux semi-conducteurs du groupe III-V pourront notamment être choisis parmi le nitrure de gallium (GaN), le nitrure d'aluminium (AlN) et leurs alliages ternaires AlxGa1-xN, ou parmi l'arséniure de gallium (GaAs) et ses composés (AlGaAs, InGaAs).

Le premier empilement 201 et le deuxième empilement 202 comprennent chacun une couche barrière et une couche canal. Notamment, le premier empilement 201 comprend, de la couche isolante 200 vers la face avant 100a, une première couche barrière 201a et une première couche canal 201b. De manière équivalente, le deuxième empilement 202 comprend, de la couche isolante 200 vers la face arrière 100b, une deuxième couche barrière 202a et une deuxième couche canal 202b.

A titre d'exemple et selon la présente invention, une couche barrière peut comprendre un alliage ternaire d'AlxGa1-xN, tandis qu'une couche canal peut comprendre du GaN.

Par ailleurs, une couche barrière peut présenter une épaisseur comprise entre 1 nm et 100 nm.

Une couche canal peut présenter une épaisseur comprise entre 10 nm et 2µm

Un empilement 201 ou 202, selon les termes de la présente invention, est apte à former une couche de gaz d'électrons à deux dimensions (2DEG pour « 2-dimensional electron gaz ») qui constitue une couche de conduction.

La couche de conduction, au sein d'un empilement, s'étend dans la couche canal, à partir de l'interface formée entre la couche barrière et la couche canal de l'empilement considéré.

Ainsi, le premier empilement 201 comprend une première couche de conduction 201c qui s'étend dans la première couche canal 201b, à partir d'une première interface formée entre la première couche barrière 201a et la première couche canal 201b.

De manière équivalente, le deuxième empilement 202 comprend une deuxième couche de conduction 202c qui s'étend dans la deuxième couche canal 202b, à partir d'une deuxième interface formée entre la deuxième couche barrière 202a et la deuxième couche canal 202b.

Le dispositif électronique 100 comporte une électrode de source 203 et une électrode de drain 204 en contact électrique avec l'une et l'autre de la première couche de conduction 201c et de la deuxième couche de conduction 202c. Rappelons que différents types de contacts électriques sont connus pour connecter électriquement les électrodes de sources 203 et de drain 204 par une couche de conduction 201c, 202c : en particulier, des contacts ohmiques, tunnel ou Schottky.

En particulier, l'électrode de source 203 et l'électrode de drain 204 traversent la couche isolante 200, et s'étendent chacune de part et d'autre de ladite couche isolante 200 pour, chacune, contacter électriquement la première couche de conduction 201c et la deuxième couche de conduction 202c.

Le dispositif électrique 100 peut comprendre un plot, dit plot source 206, disposé sur la face avant 100a et permettant de contacter électriquement l'électrode de source 203. Le plot source 206 comprend avantageusement du silicium dopé.

Le dispositif électrique 100 peut également comprendre un support contact 207 sur lequel repose les deux transistors à haute mobilité électronique. La deuxième couche canal 202b est notamment en contact avec une face du support contact 207. Le support contact est, à cet égard, destiné à contacter électriquement l'électrode de drain 204. Le support contact 207 peut avantageusement comprendre du silicium dopé.

La couche de conduction d'un transistor HEMT, lorsque ce dernier est passant, est destinée à assurer la conduction d'un courant électrique entre l'électrode de source et l'électrode de drain du transistor HEMT considéré.

Le dispositif électronique 100 selon la présente invention comprend également une électrode de grille 205. L'électrode de grille 205, à l'instar de l'électrode de source et de l'électrode de drain, est également commune au premier transistor 101 et au deuxième transistor 102.

L'électrode de grille 205 s'étend notamment, selon la direction z (perpendiculaire au plan formé par la couche isolante 200), et reste à distance de l'une et l'autre de la première couche de conduction 202a et de la deuxième couche de conduction 202c.

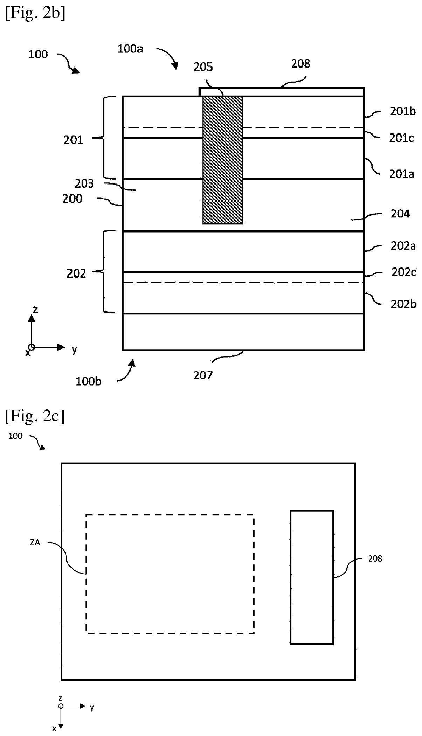

Le dispositif électrique 100 peut comprendre un plot, dit plot grille 208, disposé sur la face avant et permettant de contacter électriquement l'électrode de grille (figure 2b). Notamment, le plot grille 208 est déportée des deux transistors HEMT 101 et 102 de manière à ne pas risquer de contacter électriquement la première couche de conduction 201c. Par « déporté », on entend un plot grille qui est disposé en dehors d'un contour délimitant l'un et l'autre du premier et du deuxième transistor. A cet égard, la figure 2c est une représentation du dispositif 100 selon une vue par la face avant (selon un plan parallèle au plan (0, x, y)). Les pointillés délimitent une section active ZA du dispositif électronique au sein de laquelle tout contact entre l'électrode de grille et l'une et l'autre des couches barrière et canal est évité.

Ainsi, l'électrode de grille 205 est agencée pour piloter ou contrôler l'état de l'un et l'autre du premier transistor 101 et du deuxième transistor 102. Notamment, ce contrôle est exécuté en imposant un potentiel électrique Vg à l'électrode de grille 205, et plus particulièrement une différence de potentiel électrique DDP, noté Vg-Vs entre l'électrode de grille 205 et l'électrode de source 203.

Ainsi, dès lors que Vg-Vs est supérieure à une tension de seuil Vth caractéristique de chacun des transistors 101 et 102 ces derniers sont dans l'état passant. A contrario, dès lors que Vg-Vs est inférieure à Vth, les transistors 101 et 102 sont dans l'état non-passant, et se comportent donc comme des interrupteurs ouverts.

Aussi, dépendamment de la valeur de la tension de seuil Vth, et plus particulièrement de son signe, un transistor HEMT peut être en mode déplétion (« normally on » selon la terminologie Anglo-Saxonne) si sa tension de seuil Vth est négative, ou en mode enrichissement (« normally off » selon la terminologie Anglo-Saxonne) si sa tension de seuil Vth est positive.

Ainsi, les transistors HEMT susceptibles d'être considérés dans la présente invention peuvent être soit du type normalement passant ou à déplétion (transistor à haute mobilité électronique en mode déplétion) soit du type normalement bloqué ou à enrichissement (transistor à haute mobilité électronique en mode enrichissement).

Dans l'architecture proposée dans la présente invention, la première couche de conduction 201c et la deuxième couche de conduction 202c sont connectées en parallèle. Par conséquent, si chacun du premier transistor et du deuxième transistor présentent la même résistance Ron à l'état passant, la résistance à l'état passant Ront du dispositif électronique est égale à la résistance Ron/2.

En d'autres termes, il est possible par simple empilement de deux transistors à haute mobilité électronique d'obtenir un dispositif électronique de plus faible résistance à l'état passant sans avoir à modifier les caractéristiques géométriques desdits transistors.

Ainsi, et de manière avantageuse, le premier 201 et le deuxième 202 empilements sont essentiellement identiques.

Toujours de manière avantageuse, le premier et le deuxième transistor présentent une tension de seuil Vth identique.

De manière alternative, le premier transistor et le deuxième transistor présentent chacun, respectivement, une première tension de seuil Vth1 et une deuxième tension de seuil Vth2 différente l'une de l'autre. Ainsi, selon cette configuration, il est possible, via le contrôle de l'unique électrode de grille, de rendre passant ou non passant l'un et l'autre du premier transistor et du deuxième transistor à des instants différents. Cette configuration est par conséquence relativement avantageuse dans la mesure où elle permet de « d'étaler » un pic de courant susceptible d'apparaître lors du passage à l'état passant de ces deux transistors.

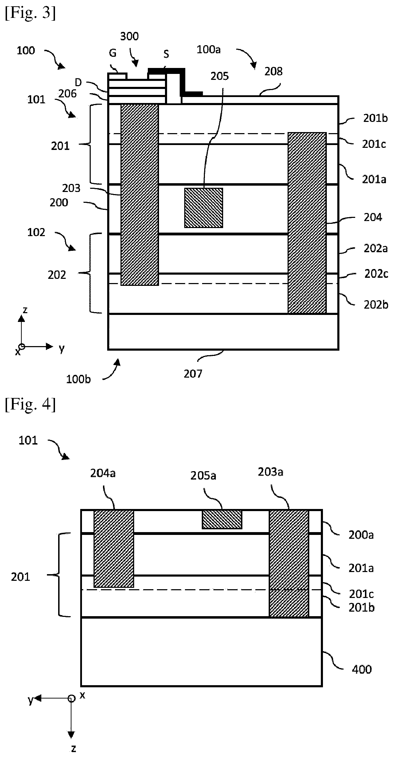

A la figure 3 on peut voir un dispositif électronique 100 selon une variante de la présente invention. Cette variante reprend l'essentiel des caractéristiques décrites en relation avec la figure 2a.

Aussi, selon cette variante, le premier transistor 101 et le deuxième transistor 102 sont normalement passant. En d'autres termes, ces deux transistors sont passants pour une différence de potentiel Vg-Vs nulle.

Ainsi, afin d'imposer une tension de seuil non nulle au dispositif électronique 100, les deux transistors 101 et 102 sont cascodés avec un transistor MOSFET 300.

Notamment, le transistor MOSFET 300 repose par son drain D sur le plot source 206, et comprend une source S connectée électriquement au plot grille 208.

Ainsi, selon cette variante, la grille G du transistor MOSFET permet d'imposer une tension au niveau de l'électrode de source 203.

La présente invention concerne également un procédé de fabrication du dispositif électronique 100 décrit ci-avant.

Notamment, le procédé comprend une étape de formation d'un premier transistor 101 (figure 4).

Notamment, la formation de ce premier transistor 101 comprend une croissance épitaxiale du premier empilement 201 sur une première face d'un premier substrat 400, par exemple un substrat de silicium. La croissance épitaxiale peut notamment comprendre en premier lieu la formation de la première couche canal 201b, puis en second lieu, la formation de la première couche barrière 201a.

La croissance épitaxiale est suivie de la formation, en recouvrement de la première couche barrière 201a, d'une première couche isolante 200a, qui comprend par exemple du dioxyde de silicium ou du nitrure de silicium.

Le dépôt de la couche isolante 200a est alors suivi de la formation d'une première électrode de source 203a, d'une première électrode de drain 204a et d'une première électrode de grille 205a. Notamment, la première électrode de source 203a s'étend de la surface libre de la première couche isolante et traverse intégralement la première couche isolante et le premier empilement 201. La première électrode de drain 204a s'étend de la surface libre de la première couche isolante jusqu'à la première couche de conduction 201c. La première électrode de grille 205a s'étend de la surface libre de la première couche isolante en direction du premier empilement et reste à distance de la couche barrière 201a.

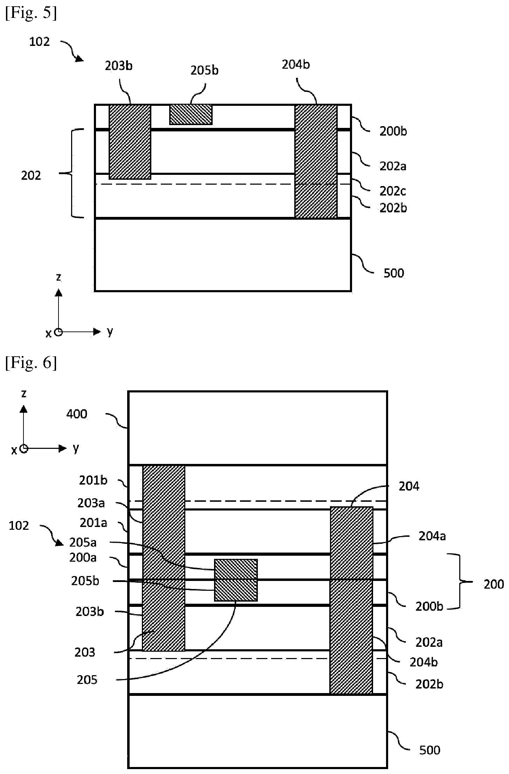

Le procédé de fabrication comprend une étape de formation d'un deuxième transistor 102 (figure 5).

Notamment, la formation de ce deuxième transistor 102 comprend une croissance épitaxiale du deuxième empilement 202 sur une première face d'un deuxième substrat 500, par exemple un substrat de silicium. La croissance épitaxiale peut notamment comprendre en premier lieu la formation de la deuxième couche canal 202b, puis en second lieu, la formation de la deuxième couche barrière 202a.

La croissance épitaxiale est suivie de la formation, en recouvrement de la deuxième couche barrière 202a, d'une deuxième couche isolante 200b, qui comprend par exemple du dioxyde de silicium ou du nitrure de silicium.

Le dépôt de la deuxième couche isolante 200b est alors suivi de la formation d'une deuxième électrode de source 203b, d'une deuxième électrode de drain 204b et d'une deuxième électrode de grille 205b. Notamment, la deuxième électrode de source 203b s'étend de la surface libre de la deuxième couche isolante jusqu'à la deuxième couche de conduction 202c. La deuxième électrode de drain 204b s'étend de la surface libre de la deuxième couche isolante pour traverser intégralement la deuxième couche isolante et le deuxième empilement 202. La deuxième électrode de grille 205a s'étend de la surface libre de la première couche isolante en direction du deuxième empilement et reste à distance de la couche barrière 202a.

Ces trois électrodes 203b, 204b et 205b s'étendent notamment d'une surface libre de la deuxième couche isolante 200b vers le deuxième empilement 202.

En particulier, l'électrode de drain s'étend jusqu'à l'interface formée entre le deuxième empilement 202 et le deuxième substrat 500.

Le procédé de fabrication comprend également une étape d'assemblage du premier transistor 101 et du deuxième transistor 102 (figure 6). A cet égard, l'étape d'assemblage est exécutée par mise en contact de la première couche isolante 200a avec la deuxième couche isolante 200b, et de sorte que la première électrode de source 203a, la première électrode de drain 204a et la première électrode de grille 205a soient dans le prolongement, respectivement, de la deuxième électrode de source 203b, la deuxième électrode de drain 204b et la deuxième électrode de grille 205b.

En d'autres termes, l'assemblage de la première couche isolante avec la deuxième couche isolante forme la couche isolante 200. L'assemblage de la première électrode de source 203a avec la deuxième électrode de source 203b forme l'électrode de source 203. L'assemblage de la première électrode de drain 204a avec la deuxième électrode de drain 204b forme l'électrode de drain 204. L'assemblage de la première électrode de grille 205a avec la deuxième électrode de grille 205b forme l'électrode de grille 205.

Il est par ailleurs notable que cette étape d'assemblage peut se faire selon un mode plaque à plaque. Plus particulièrement, le procédé peut comprendre la formation d'une pluralité de premiers transistors formés sur le premier substrat, et une pluralité de deuxième transistors formés sur le deuxième substrat. Ces deux substrats sont ensuite assemblés de manière à mettre chaque premier transistor en vis-à-vis d'un deuxième transistor.

De manière alternative, l'assemblage peut comprendre une étape de préhension/positionnement (« Pick and Place » selon la terminologie Anglo-Saxonne). Notamment, chaque premier transistor peut être placé de manière individuelle sur chaque deuxième transistor formé sur la deuxième substrat.

Enfin, et toujours de manière alternative, les premiers transistors et les deuxièmes transistors sont tous singularisés, et ensuite assemblés deux-à-deux.

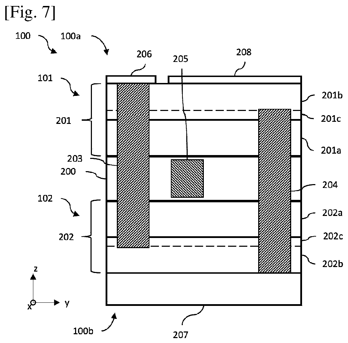

Dans une dernière étape, les plots source et grille sont formés par amincissement et gravure du premier substrat (figure 7).

Le dispositif électronique selon la présente invention est avantageusement mis en œuvre dans un système de gestion/consommation d'énergie électrique.

Plus particulièrement, le système de gestion peut comprendre un moyen de stockage d'énergie et une voie de consommation de ladite énergie. Le moyen de stockage est par exemple une batterie ou un accumulateur.

La voie de consommation peut être un moteur électrique. Ainsi, le dispositif électronique 100 selon la présente invention est avantageusement mis en œuvre dans un véhicule (voiture, camion, vélo, train) électrique.

## Revendications

1. Dispositif électronique (100) comprenant deux transistors à haute mobilité électronique dits, respectivement, premier (101) et deuxième (102) transistors, le premier (101) et le deuxième (102) transistors étant chacun pourvus d'un empilement dits, respectivement, premier (201) et deuxième (202) empilements et entre lesquels est intercalée une couche isolante (200), le premier (201) et le deuxième (202) empilements s'étendent, de la couche isolante (200) vers, respectivement, une face avant (100a) et une face arrière (100b) du dispositif électronique, et comprennent chacun, à partir de la couche isolante (200), une couche barrière (202a, 202b) et une couche canal (201a, 201b) apte à former une couche de conduction (201c, 202c) sous forme d'un gaz d'électrons à deux dimensions, les deux transistors ayant en commun une électrode de source (203) et une électrode de drain (204) agencées de sorte que des chemins de conduction électrique susceptibles d'être formés par les deux couches de conduction (201c, 202c) soient connectés en parallèle, les deux transistors (101, 102) ont également en commun une électrode de grille (205) permettant d'imposer un état passant ou un état non passant à l'une et l'autre des deux couches de conduction.

2. Dispositif selon la revendication 1, dans lequel la couche isolante (200) comprend un matériau diélectrique, avantageusement, du dioxyde de silicium.

3. Dispositif selon la revendication 1 ou 2, dans lequel l'électrode de source (203) et l'électrode de drain (204) traversent la couche isolante, et s'étendent chacune de part et d'autre de ladite couche isolante (200) pour, chacune, contacter électriquement les deux couches de conduction (201c, 202c).

4. Dispositif selon l'une des revendications 1 à 3, dans lequel ledit dispositif électrique comprend un plot, dit plot source, disposé sur la face avant et permettant de contacter électriquement l'électrode de source (203).

5. Dispositif selon l'une des revendications 1 à 4, dans lequel ledit dispositif électrique comprend un support contact sur lequel reposent les deux transistors à haute mobilité électronique par la couche barrière (202a, 202b) sur le deuxième transistor.

6. Dispositif selon l'une des revendications 1 à 5, dans lequel ledit dispositif électrique comprend un plot, dit plot grille, disposé sur la face avant et permettant de contacter électriquement l'électrode de grille (205).

7. Dispositif selon l'une des revendications 1 à 6, dans lequel le premier et le deuxième empilement sont essentiellement identiques.

8. Dispositif selon l'une des revendications 1 à 7, dans lequel le premier et le deuxième transistor présentent une tension de seuil identique.

9. Dispositif selon l'une des revendications 1 à 7, dans lequel le premier et le deuxième transistor présentent chacun, respectivement, une première tension de seuil et une deuxième tension de seuil différentes l'une de l'autre.

10. Dispositif selon l'une des revendications 1 à 9, dans lequel le premier et le deuxième transistor sont des transistors à haute mobilité électronique en mode enrichissement.

11. Dispositif selon l'une des revendications 1 à 9, dans lequel le premier et le deuxième transistor sont des transistors à haute mobilité électronique en mode déplétion.

12. Dispositif selon la revendication 11, dans lequel l'électrode de source (203) est cascodée avec un transistor à effet de champ à grille métal-oxyde.

13. Dispositif selon l'une des revendications 1 à 12, dans lequel les deux couches canal comprennent du GaN et les couches barrière comprennent un alliage ternaire d'AlGaN.
